# FASCICULE DE BREVET EUROPEEN

(11) **EP 3 886 460 B1**
(45) Date de publication et mention de la délivrance du brevet: **10.12.2025**
(21) Numéro de dépôt: 21163869.7
(22) Date de dépôt: 22.03.2021
(51) Int. Cl.: H04R 19/00, H04R 19/04

(54) **MICROPHONE MICROELECTROMECANIQUE A ENCOMBREMENT REDUIT**
MIKROELEKTROMECHANISCHES MIKROPHON MIT REDUZIERTEM PLATZBEDARF
COMPACT MICROELECTROMECHANICAL MICROPHONE

(30) Priorité: 23.03.2020 FR 2002826
(43) Date de publication de la demande: 29.09.2021
(73) Titulaire: Commissariat à l'Energie Atomique et aux Energies Alternatives, 75015 Paris (FR)
(72) Inventeur: DAGHER, Samer, 38054 Grenoble Cedex 09 (FR); JOET, Loic, 38054 Grenoble Cedex 09 (FR)
(74) Mandataire: Santarelli

(56) Documents cités:
- FR-A1- 3 059 659
- US-A1- 2017 041 692
- TOLGA TEKIN: "Review of Packaging of Optoelectronic, Photonic, and MEMS Components", IEEE JOURNAL OF SELECTED TOPICS IN QUANTUM ELECTRONICS, IEEE SERVICE CENTER, PISCATAWAY, NJ, US, vol. 17, no. 3, 1 May 2011 (2011-05-01), pages 704 - 719, XP011326481, ISSN: 1077-260X, DOI: 10.1109/JSTQE.2011.2113171
- "Handbook of Silicon Based MEMS Materials and Technologies", 22 February 2010, ELSEVIER SCIENCE & TECHNOLOGY BOOKS, ISBN: 978-0-81-551594-4, article ARI LEHTO ET AL: "PART V Encapsulation of MEMS Components", pages: 499 - 616, XP055750042

## Description

La présente invention se rapporte à un microphone microélectromécanique et à un procédé de fabrication d'un microphone microélectromécanique.

Les microphones microélectromécaniques ou MEMS (Microelectromechanical systems en terminologie anglo-saxonne) équipent de nombreux objets, par exemple les téléphones portables, les assistants électroniques personnels. Leur demande est en augmentation. En outre, on cherche à réaliser des microphones à la fois plus performants et moins encombrants. Or la réduction de la taille des microphones intervient dans leurs performances.

Un microphone MEMS comporte un élément sensible à une différence de pression, dont une face est en contact avec la zone dans laquelle l'onde sonore à capter est émise, et une face est en contact avec une cavité, appelée volume arrière. Le volume arrière est généralement relié à l'environnement extérieur pour permettre l'égalisation de la pression à la pression atmosphérique à basse fréquence. Cette cavité présente généralement un volume de quelques mm³ à quelques dizaines de mm³. Plus ce volume est grand et plus le bruit acoustique associé à ce volume diminue. Des moyens mesurent le déplacement de l'élément sensible. Ces moyens de mesure sont généralement de type capacitif, l'élément sensible forme une électrode et une contre-électrode qui est disposée en regard de l'élément sensible. La contre-électrode est ajourée pour permettre à l'onde sonore d'atteindre l'élément sensible. La contre-électrode forme néanmoins une résistance acoustique, ce qui dégrade le seuil de détection et engendre aussi un amortissement, ce qui réduit la bande passante du microphone.

Généralement la fabrication d'un microphone MEMS comporte l'étape de fabrication d'un ensemble comprenant un élément sensible suspendu à un substrat, et des moyens de mesure de son déplacement par rapport au substrat, l'assemblage sur une face de l'ensemble avec un support comportant au moins un passage au droit de l'élément sensible pour connecter l'élément sensible à l'environnement extérieur, et le report d'un capot sur le support délimitant avec l'élément sensible le volume arrière. Un tel microphone est encombrant. En outre il présente le problème de la résistance acoustique due à la contre-électrode.

Une possibilité pour résoudre le problème de la résistance de la contre-électrode, est de placer les moyens de mesure capacitifs dans une atmosphère contrôlée. Cependant il devient relativement complexe de prévoir un espace sous atmosphère contrôlée et un volume arrière tout en offrant un microphone d'encombrement raisonnable, et dont l'étape de packaging serait relativement simple.

Le document FR 3 059 659 A1 divulgue un microphone permettant la transmission d'un mouvement et d'une force entre une première zone et une deuxième zone isolées l'une de l'autre de manière étanche, la deuxième zone formant un espace sous atmosphère contrôlée dans lequel sont disposés des moyens de mesure.

### EXPOSÉ DE L'INVENTION

C'est par conséquent un but de la présente invention d'offrir un microphone microélectromécanique performant, dont les moyens de transduction sont placés dans une atmosphère contrôlée, et dont le volume arrière est intégré au MEMS, simplifiant son intégration et minimisant sa taille finale et un procédé de fabrication d'un tel microphone.

Le but énoncé ci-dessus est atteint par un microphone microélectromécanique réalisé à partir de deux substrats assemblés, un premier dans lequel est réalisée l'unité microphone et un deuxième substrat formant le capot, également désigné packaging. Le deuxième substrat comporte au moins un évidement formant avec le premier substrat une première cavité recevant l'élément sensible du microphone et délimitant le volume arrière. Le premier et le deuxième substrat délimitent également un espace, dans lequel règne une atmosphère contrôlée, avantageusement à faible pression, recevant les moyens de mesure du déplacement de l'élément sensible, cet espace étant isolé de manière étanche de la première cavité. Un moyen de transmission assure une transmission du déplacement du piston vers l'espace sous atmosphère contrôlée, tout en assurant un isolement de cet espace et de la première cavité.

Ainsi le volume arrière et l'espace sous atmosphère contrôlée sont directement formés lors de l'assemblage des deux substrats, il n'est donc pas requis de la fabriquer après assemblage. Le microphone est alors directement fonctionnel après assemblage de l'unité microphone et du capot.

Grâce à l'invention, le microphone présente un haut niveau d'intégration et un encombrement réduit.

Le but ci-dessus est également atteint par un procédé de fabrication de microphones microélectromécaniques comportant la fabrication d'un premier sous-ensemble comprenant au moins un élément sensible et des moyens de mesure disposés sensiblement dans le même plan et relié par un bras articulé en rotation autour d'un axe contenu dans le plan, ledit bras transmettant le déplacement de l'élément sensible aux moyens de mesure, et la fabrication d'un deuxième sous-ensemble comportant au moins une première cavité pour l'élément sensible, et l'assemblage des deux sous-ensembles de sorte que la première cavité forme un volume arrière pour l'élément sensible et qu'ils délimitent, pour les moyens de mesure, un espace isolé de l'environnement extérieur.

Le procédé selon l'invention met en œuvre uniquement deux sous-ensembles, i.e. il utilise deux substrats qui sont structurés puis assemblés. Le procédé de fabrication est simplifié. En outre les moyens de mesure du microphone n'étant pas en regard de l'élément sensible, ils ne réduisent pas les performances du microphone.

En d'autres termes, le microphone et le procédé mettent en œuvre un substrat comportant les éléments du microphone et un substrat capot ou de packaging.

De manière avantageuse, le premier sous-ensemble comporte plusieurs paires d'éléments sensible / moyens de mesure et le deuxième sous-ensemble au moins plusieurs premières cavités, permettant de fabriquer simultanément plusieurs microphones. Les microphones sont ensuite singularisés, par exemple par découpe.

La présente invention a alors pour objet un microphone microélectromécanique selon la revendication 1.

Dans un exemple avantageux, le capot comporte un deuxième évidement qui délimite avec l'unité microphone l'espace sous vide.

Selon l'invention, l'espace étanche et la première cavité sont d'un même côté du plan de l'élément d'isolation étanche.

Dans un exemple de réalisation, les moyens de connexion sont dans le capot et sont formés par au moins un via et/ou de pistes de connexion s'étendant dans le plan du capot.

Par exemple, les moyens de connexion sont dans l'unité microphone et sont formés par au moins un via.

L'unité de commande peut être un ASIC intégré au premier substrat ou au deuxième substrat.

Par exemple, les moyens de mesure sont capacitifs et comprennent une électrode fixe sur le premier substrat et une électrode solidaire des moyens de transmission.

Dans un autre exemple, les moyens de mesure sont des moyens de mesure mettant en œuvre des poutres résonantes.

La présente invention a également pour objet un procédé de fabrication d'au moins un microphone selon la revendication 7.

Lors de l'assemblage du premier sous-ensemble et du deuxième sous-ensemble, une atmosphère contrôlée est établie dans la chambre de mesure.

Un matériau getter peut être formé sur le deuxième sous-ensemble de sorte à ce que le matériau getter soit dans la chambre de mesure.

Avantageusement, lors de l'étape b), une deuxième cavité adjacente à la première cavité est formée et délimite avec le deuxième sous-ensemble la chambre de mesure.

Dans un exemple de réalisation, la fabrication des premiers moyens de connexion comporte la réalisation d'un via à travers le premier sous-ensemble débouchant en face avant du premier sous-ensemble et se connectant directement aux moyens de mesure.

Les premiers moyens de connexion peuvent être fabriqués sur le deuxième sous-ensemble et l'étape f) peut comporter la découpe d'une partie du premier sous-ensemble pour accéder aux premiers moyens de connexion électrique du deuxième sous-ensemble, et la connexion des premiers moyens de connexion électrique à l'unité de commande.

L'étape f) comporte avantageusement une étape d'encapsulation de l'unité de commande, des premiers moyens de connexion électrique et d'une partie du premier sous-ensemble et du deuxième sous-ensemble.

L'unité de commande peut être un ASIC (AS) et le procédé peut comporter une étape d'intégration de l'ASIC dans le premier ou le deuxième sous-ensemble. Le procédé peut alors comporter la fabrication d'un logement en face avant du premier ou deuxième sous-ensemble et mise en place de l'ASIC dans ledit logement.

Le procédé peut également comporter la réalisation de deuxièmes moyens de connexion à l'ASIC et la réalisation d'un via dans le premier sous-ensemble ou le deuxième sous-ensemble de sorte qu'il se connecte aux deuxièmes moyens de connexion.

Dans un autre exemple de réalisation, le deuxième sous-ensemble est formé à partir d'un substrat, ledit substrat étant un ASIC.

De préférence, plusieurs microphones sont fabriqués simultanément, lesdits premiers sous-ensembles étant réalisés à partir d'un même substrat et lesdits deuxièmes sous-ensembles étant réalisés à parti d'un même deuxième substrat, ledit procédé comportant une étape de séparation des microphones après l'étape e).

### BRÈVE DESCRIPTION DES DESSINS

La présente invention sera mieux comprise sur la base de la description qui va suivre et des dessins en annexe sur lesquels :
La figure 1 est une vue en coupe d'un exemple de microphone obtenu par le procédé de fabrication selon l'invention,
Les figures 2A à 2M sont des représentations schématiques d'éléments obtenus à différentes étapes d'un exemple de procédé de fabrication selon l'invention,
Les figures 3A et 3B sont des représentations schématiques d'étapes de séparation des microphones lorsque plusieurs microphones sont réalisés simultanément,
La figure 4 représente une vue en coupe d'un autre exemple de réalisation d'un microphone obtenu par un exemple de procédé de fabrication selon l'invention, dans lequel un ASIC est intégré en face avant du deuxième sous-ensemble,
La figure 5 représente une vue en coupe d'une autre variante de l'étape de connexion électrique des moyens de mesure du microphone de la figure 4,
La figure 6 représente une vue en coupe d'une autre variante de l'étape de connexion électrique des moyens de mesure du microphone de la figure 2K,
La figure 7 représente une vue en coupe d'une autre variante de l'étape de connexion électrique des moyens de mesure du microphone de la figure 4,
La figure 8 représente une vue en coupe d'un autre exemple de réalisation d'un microphone obtenu par un exemple de procédé de fabrication selon l'invention, dans lequel un ASIC est intégré en face avant du premier sous-ensemble,
La figure 9 représente une vue en coupe d'un autre exemple de réalisation d'un microphone obtenu par un exemple de procédé de fabrication selon l'invention, dans lequel le substrat du deuxième sous-ensemble est un ASIC,
La figure 10 est une vue en coupe en perspective d'un autre exemple de microphone obtenu par un exemple de procédé de fabrication selon l'invention, représenté partiellement,
Les figures 11A à 11D sont des représentations schématiques des étapes d'une variante de fabrication du deuxième sous-ensemble,
La figure 12 représente une vue en coupe d'une autre d'un microphone dans laquelle l'unité de commande est extérieur.

### EXPOSÉ DÉTAILLÉ DE MODES DE RÉALISATION PARTICULIERS

Les mêmes références sont utilisées pour décrire des éléments ayant sensiblement la même structure ou sensiblement la même fonction.

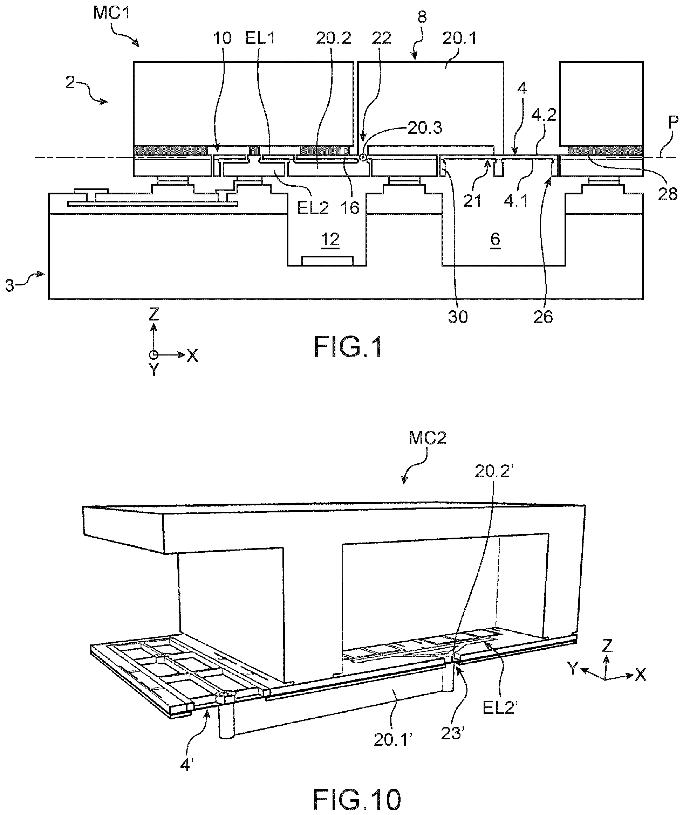

Sur la figure 1, on peut voir un exemple de réalisation d'un microphone MC1 selon l'invention.

Le microphone comporte une unité microphone 2 et un capot 3.

L'unité microphone 2 comporte les éléments de captation de la variation de pression et la mesure de celle-ci. Cette unité de microphone est réalisée à partir d'un premier substrat, le capot est réalisé par un deuxième substrat et le microphone est obtenu directement après assemblage des premier et deuxième substrats sans requérir d'étape additionnelle.

L'unité microphone comporte un piston 4 ou élément sensible aux variations de pression, des moyens de mesure 10 du déplacement du piston, des moyens de transmission mécanique 8 du déplacement du piston aux moyens de mesure et un élément d'isolation étanche entre la partie de captation de la variation de pression et la partie de mesure de cette variation de pression.

Le capot comporte dans l'exemple représenté un premier évidement qui forme le volume arrière et un deuxième évidement qui délimite avec l'unité microphone une cavité à atmosphère contrôlée. Le microphone comporte dans cet exemple, par assemblage de l'unité microphone et du capot, directement deux cavités isolées l'une de l'autre de manière étanche.

Le piston 4 est suspendu entre une chambre 6 appelée volume arrière et une zone A dont on veut mesurer les variations de pression dues aux ondes acoustiques. Le piston comporte une face 4.1 orientée vers le volume arrière et une face 4.2 tournée avec la zone A. Le piston 4 se déplace sensiblement dans une direction hors-plan Z. Le plan du microphone est un plan parallèle aux directions dans lesquelles s'étendent les plus grandes dimensions du support et du capot.

Les moyens de mesure 10 sont disposés sensiblement dans le plan du piston et sont disposés dans une chambre 12 isolée de la zone A et du volume arrière, la chambre 12 sera appelée la chambre de mesure.

Les moyens de transmission mécanique 8 assurent une transmission du déplacement du piston vers la chambre de mesure 12 tout en assurant un isolement de la chambre de mesure 12 de la zone A et du volume arrière 6.

Dans l'exemple représenté les moyens de mesure 10 sont de type capacitif et détectent une variation d'entrefer entre une électrode mobile EL1 solidaire en mouvement des moyens de transmission et une électrode fixe EL2 fixée au support. Par exemple l'électrode mobile EL1 est reliée à la masse et l'électrode fixe EL2 est reliée à une source de tension, imposant une différence de potentiel entre les deux électrodes.

La chambre de mesure 12 comporte une atmosphère contrôlée, avantageusement sous vide. la présente demande, on entend par « chambre sous atmosphère contrôlée », une chambre dans la composition gazeuse et la pression ne varient pas ou peu dans le temps, plusieurs mois, voire plusieurs années, et on entend par « chambre sous vide », une chambre sous atmosphère raréfiée, i.e. à une pression inférieure à la pression de l'environnement extérieur, de préférence très inférieure à la pression de l'environnement extérieur, de préférence à une comprise entre de l'ordre de 0,1 mBar à 10 mBars. Par exemple la pression dans la chambre de mesure 12 est au moins inférieure à 0,1 bar, voire inférieure à 0,01 bar. Le fait de réduire la pression dans la chambre de mesure 12 permet de diminuer les bruits thermiques et les amortissements visqueux intrinsèques aux déplacements d'air entre les électrodes.

En variante, les moyens de mesure sont réalisés par un ou des résonateurs, par exemple des poutres résonantes, type corde de guitare, disposées avantageusement dans une atmosphère à basse pression de préférence entre l'ordre de 0,1 mBar à 10 mBars. Le fonctionnement dans une atmosphère à basse pression permet de réduire le frottement, ce qui améliore le facteur de qualité et le gain de transduction.

Les moyens de transmission comportent un ou plusieurs éléments de transmission parallèles s'étendant au repos le long d'un axe X contenu dans le plan et articulé(s) en rotation par une articulation pivot 22 sur le support 2. Dans cet exemple le ou les éléments de transmission sont rigides ou peu déformables. En variante, lorsque plusieurs éléments de transmission sont mis en œuvre, ceux-ci peuvent s'étendre selon l'axe X, l'axe Y ou tout angle intermédiaire.

Chaque élément de transmission comporte un premier bras de transmission 20.1 disposé dans l'environnement extérieur A et un deuxième bras de transmission 20.2 disposé dans la chambre de mesure 12. Dans cet exemple les deux bras de transmission 20.1, 20.2 sont alignés.

Dans l'exemple représenté, le premier bras de transmission 20.1 et le deuxième bras de transmission 20.2 sont reliés rigidement par une portion centrale 20.3, appelée arbre de transmission.

Dans l'exemple représenté, le premier bras de transmission 20.1 et le deuxième bras de transmission 20.2 sont disposés dans deux plans distincts, le premier bras de transmission 20.1 étant situé au-dessus d'un plan P contenant le piston et l'électrode mobile, et le deuxième bras de transmission 20.2 est situé au-dessous du plan P.

L'élément d'isolation étanche 16 est situé dans le plan P et isole de manière étanche la chambre de mesure 12 et la zone A. L'élément d'isolation étanche 16 est adapté pour supporter la différence de pression entre l'environnement extérieur et la pression dans la chambre de mesure 12, notamment lorsque la pression dans la chambre de mesure 12 est réduite par rapport à celle de l'environnement extérieur.

L'arbre de transmission 20.3 traverse l'élément d'isolation étanche 16.

Dans l'exemple représenté, le premier bras de transmission 20.1 se raccorde à une première zone de la face latérale de l'arbre de transmission 20.3 et le deuxième bras de transmission 20.2 se raccorde à l'arbre de transmission en une deuxième zone de sa face latérale, opposée à la première zone.

L'extrémité libre du premier bras de transmission 20.1 peut être reliée au piston 4 par une articulation transmettant le déplacement le long de la direction Z, tout en autorisant la rotation autour de l'axe Y et la translation le long de l'axe X. Cette liaison autorise la cohabitation entre la rotation du bras et de la translation selon Z du piston. Le piston peut aussi être directement lié à l'extrémité 20.1. Il est alors maintenu en rotation par le bras, comme représenté sur la figure 1

De même, l'extrémité libre du bras de transmission 20.2 peut être reliée à l'électrode mobile par une articulation transmettant le déplacement le long de la direction Z tout en autorisant la rotation autour de l'axe Y et la translation le long de l'axe X, ce qui permet d'implémenter une électrode en translation selon Z. L'électrode mobile peut aussi être directement liée à l'extrémité du bras 20.2 et se déplacer en rotation, comme représenté sur la figure 1.

L'arbre de transmission est articulé en rotation autour de l'axe Y par rapport au support 2, dans la zone qui traverse l'élément d'isolation étanche. L'articulation est par exemple réalisée au moyen de lames (non visibles) alignées avec l'axe Y et aptes à se déformer en torsion autour de l'axe Y.

De préférence, les lames assurant l'articulation en rotation des bras de transmission par rapport au support présentent une dimension importante selon la direction Z, offrant ainsi une grande rigidité dans la direction hors-plan Z, ce qui limite avantageusement le déplacement hors-plan de l'élément de transmission. Ainsi la différence de pression entre l'environnement extérieur et la chambre de mesure ne tend pas à déplacer l'élément de transmission et n'influe pas sur la mesure.

De préférence, le piston 4 est suspendu au support par des éléments de suspension comportant des lames déformables en flexion dans la direction hors-plan et autorisant le piston à se déplacer dans la direction Z.

En mettant en œuvre plusieurs bras de transmission, les efforts sont récupérés à plusieurs endroits du piston, la réalisation du piston peut être facilitée. Inversement le dispositif pourrait comporter plusieurs membranes reliées à un seul bras de transmission.

Des moyens de transmission mettant en œuvre un seul bras de transmission ne sortent pas du cadre de la présente demande.

Dans l'exemple représenté, le piston est détouré et rigidifié par un ou des renforts. Le piston comporte une structure de rigidification 26 d'une couche fine 28 récoltant la différence de pression sur toute la surface, la fine couche 28 étant issue de la couche formant également l'élément d'isolation étanche. La couche 28 a une épaisseur par exemple comprise entre quelques centaines de nanomètres et quelques micromètres.

La structure de rigidification comprend avantageusement un rebord 30 s'étendant dans la direction Z sur son contour extérieur, de sorte à allonger le chemin de l'air entre la zone A et la chambre 6 tout autour du piston, et ainsi réduire les fuites entre l'extérieur et le volume arrière servant de référence.

Grâce à la structure mise en œuvre, la pression est collectée sur toute la surface et l'énergie perdue dans la déformation du piston est négligeable.

La mise en œuvre d'une couche fine 28 pour l'étanchéité et d'une structure de rigidification 26 permet de réaliser un piston présentant une rigidité élevée, ce qui limite les pertes d'énergie en déformation, tout en limitant avantageusement la masse. En effet une augmentation de la masse provoque une perte en bande passante.

En outre, le piston peut prendre une forme quelconque permettant d'optimiser la taille du système microélectromécanique et/ou nanoélectromécanique.

De plus, l'élément d'isolation étanche 16 limite les déplacements dans le plan XY.

L'élément d'isolation étanche 16 est tel qu'il se déforme sous l'effet du déplacement des bras de transmission en rotation, la raideur de l'élément d'isolation est assez faible pour ne pas apporter de contrainte supplémentaire, notamment elle ne nécessite pas d'augmentation de la surface du piston.

L'élément d'isolation étanche 16 et les lames de torsion se déforment facilement pour permettre la rotation des bras de transmission autour de Y et s'opposent aux mouvements dans directions X, Y et Z au niveau de cet axe de rotation. La part d'énergie perdue, lors de la transmission du mouvement utile, est limitée, l'articulation présente alors un très bon rendement mécanique.

Comme cela a été décrit pour le piston 4, l'électrode mobile peut être reliée à plusieurs éléments de transmission ayant des axes de rotation différents, par l'intermédiaire d'une liaison mécanique autorisant une rotation hors-plan entre le bras et l'électrode mobile. Ainsi l'électrode mobile a un déplacement en translation le long de l'axe Z, à condition que les éléments de transmission transmettent tous le même déplacement.

En variante, les moyens de mesure capacitifs pourraient être à variation de surface en utilisant des peignes interdigités.

Sur la figure 10, on peut voir un autre exemple de microphone MC2. Le microphone de la figure 10 diffère de celui de la figure 1 en ce que l'articulation 20.3' des bras de transmission 20.2' est située au centre de l'électrode mobile EL2' des moyens de mesure, il en résulte que l'électrode mobile EL2' pivote autour d'un l'axe Y placé en son milieu. Lors du déplacement du piston 4', on réalise une mesure différentielle car il y a, à la fois, une capacité croissante et une capacité décroissante. Cet exemple de réalisation présente l'avantage d'avoir une électrode mobile équilibrée.

Un exemple d'un procédé de fabrication selon l'invention d'un microphone présentant des performances améliorées va maintenant être décrit.

Le procédé de fabrication comporte les étapes suivantes :
- la fabrication d'un premier sous-ensemble, formant l'unité microphone, comportant le piston, les moyens de mesure et au moins une partie des moyens de transmission, également désigné sous-ensemble microphone E1,
- la fabrication d'un deuxième sous-ensemble E2, formant le capot, destiné à délimiter avec le sous-ensemble microphone le volume arrière du microphone et la chambre de mesure,
- la réalisation de premiers moyens de connexion électrique,
- l'assemblage du premier E1 et deuxième E2 sous-ensemble,
- la structuration du premier sous-ensemble par la face arrière pour finaliser les moyens de transmission,
- la connexion des moyens de mesure à une unité de commande UC.

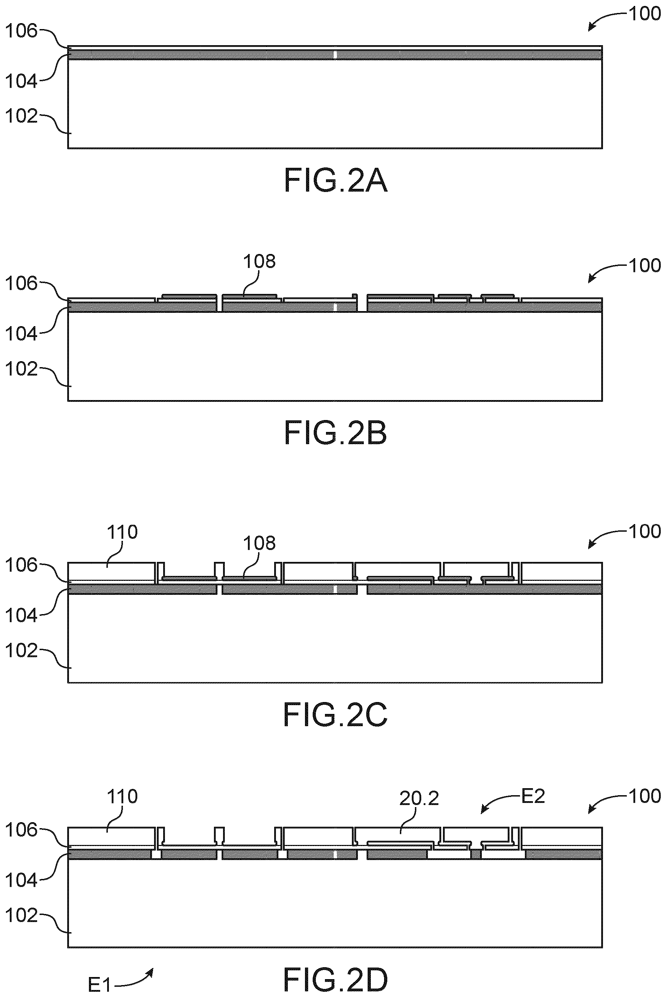

Un exemple de réalisation du premier sous-ensemble E1 va maintenant être décrit en relation avec les figures 2A à 2D. Cet exemple n'est pas limitatif.

On utilise par exemple un substrat 100 en silicium sur isolant ou SOI (Silicon On Insulator en terminologie anglo-saxonne) comportant une couche de silicium épaisse 102, une couche de SiO₂ 104 et une couche de silicium monocristallin 106.

Le substrat est représenté sur la figure 2A.

La couche 106 est structurée par exemple par photolithographie et gravure. Puis une couche de SiO₂ 108 est formée sur la couche 106 structurée, par exemple par dépôt, par exemple par dépôt chimique en phase vapeur ou tout autre type de dépôt qui convient. La couche 106 forme la partie fine du piston et l'élément d'isolation étanche.

La couche 108 est également structurée par exemple par photolithographie et gravure. La gravure de la couche 108 peut aussi entraîner la gravure de la couche 104 là où la couche 106 a été précédemment gravée, comme c'est le cas sur la figure 2B.

Lors d'une étape suivante, on forme une couche de silicium épaisse 110 par exemple par croissance épitaxiale. Puis la couche 110 est gravée, par exemple par gravure ionique réactive profonde ou DRIE (Deep Reactive Ion Etching).

L'élément ainsi obtenu est représenté sur la figure 2C.

Lors d'une étape suivante, le piston, l'électrode mobile et le deuxième bras de transmission 20.2 sont libérés par gravure du SiO₂ des couches 104 et 108, par exemple par gravure à l'acide fluorhydrique en phase vapeur. Il s'agit d'une gravure contrôlée en temps.

L'élément ainsi obtenu est représenté sur la figure 2D, il s'agit du premier sous-ensemble E1.

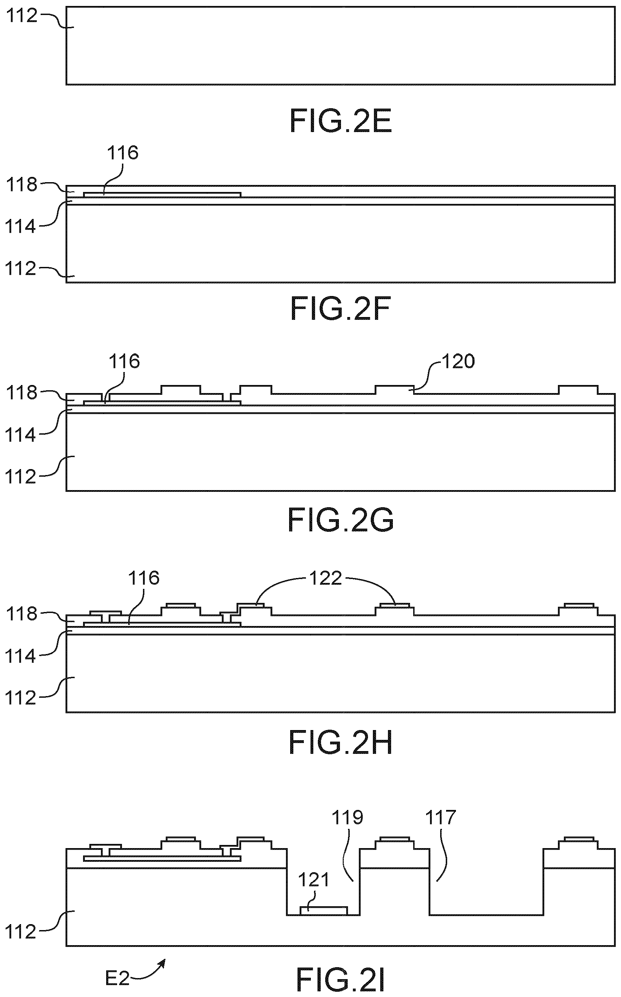

Un exemple de fabrication du deuxième sous-ensemble E2 va maintenant être décrit en relation avec les figures 2E à 2I. Cet exemple n'est pas limitatif.

On utilise par exemple un substrat en silicium 112 représenté sur la figure 2E.

On forme successivement une couche de SiO₂ 114 pleine plaque par dépôt ou oxydation thermique, une couche de métal 116, par dépôt chimique en phase vapeur ou tout autre type de dépôt, qui est structurée, puis on forme une couche de SiO₂ 118 pleine plaque.

La couche de métal est destinée à former des premiers moyens de connexion électriques.

L'élément obtenu est représenté sur la figure 2F.

Lors d'une étape suivante, une couche 120 est formée sur la couche 118 puis elle est structurée, par exemple par gravure, pour former deux tranchées pour accéder à la couche de métal 116. Elle peut aussi être structurée de manière à réaliser des surépaisseurs à certains endroits. Pour cela, on peut envisager une gravure partielle, contrôlée en temps, ou l'ajout d'une couche d'arrêt, par exemple en SiN au cœur de la couche 120, pour arrêter la gravure lors de sa gravure.

L'élément obtenu est représenté sur la figure 2G.

Lors d'une étape suivante, on forme une couche de métal 122 et on la structure de sorte à former dans celle-ci des reprises de contact sur les premiers moyens de connexion électriques formés dans la couche de métal 116 au niveau des tranchées. De manière avantageuse, la couche de métal 122, en plus de permettre la réalisation de reprises de contact, assure l'assemblage mécanique des deux sous-ensembles et l'isolation étanche de la chambre de mesure. Par exemple, la couche 122 est structurée afin de former des cordons de scellement pour réaliser un scellement eutectique.

L'élément obtenu est représenté sur la figure 2H.

Lors d'une étape suivante, l'élément de la figure 2H est structuré pour former des cavités 117, 119 destinées à former le volume arrière et la chambre de mesure respectivement. Par exemple les couches de SiO₂ et le substrat 112 sont gravés par gravure réactive ionique profonde ou DRIE (Deep Reactive Ion Etching en terminologie anglo-saxonne).

Dans l'exemple représenté, un matériau Getter 121 est déposé dans le fond de la cavité 119 pour confirmer la faible pression dans la chambre de mesure.

L'élément obtenu est représenté sur la figure 2I, il s'agit du deuxième sous-ensemble E2.

Ensuite les sous-ensembles E1 et E2 sont assemblés par exemple par scellement eutectique, par exemple aluminium-germanium par leurs faces avant. Le scellement est choisi par exemple parmi le scellement métal-métal, le scellement eutectique métallique, le soudage et le scellement par adhésif conducteur.

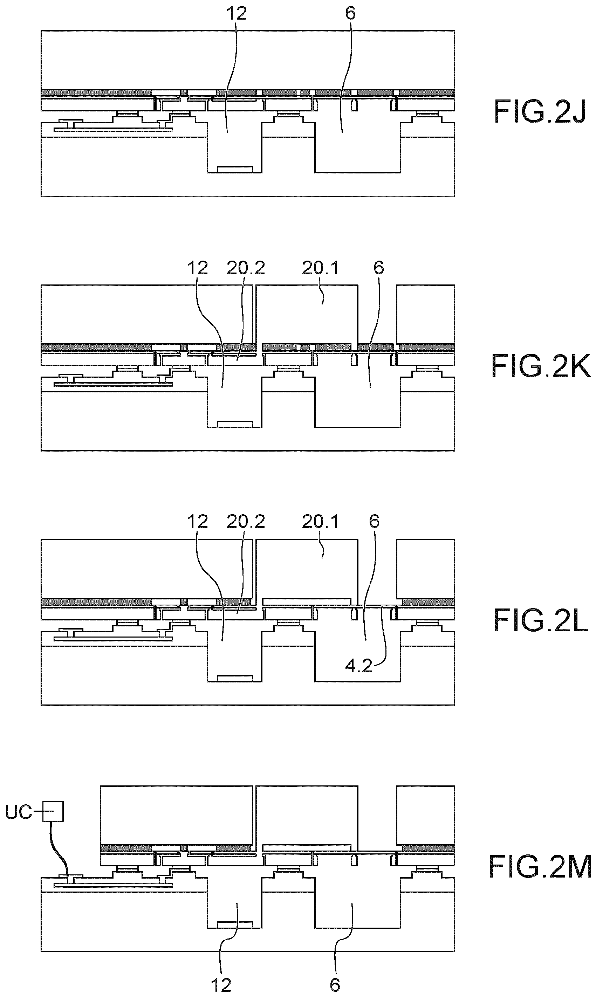

L'élément obtenu est représenté sur la figure 2J.

On réalise ensuite une étape d'amincissement de la couche 102 par grinding pour obtenir une épaisseur réduite, typiquement une épaisseur d'une centaine de microns. Lors d'une étape, on forme le premier bras de transmission 20.1 par structuration du substrat 102, par exemple par gravure dans la face arrière du premier sous-ensemble.

L'élément obtenu est représenté sur la figure 2K.

Lors d'une étape suivante, le premier bras de transmission et la face 4.2 du piston sont libérés par exemple par gravure à l'acide fluorhydrique en phase vapeur. Il s'agit d'une gravure contrôlée en temps.

L'élément obtenu est représenté sur la figure 2L.

Lors d'une étape suivante, on structure le substrat pour assurer une connexion des moyens de mesure à une unité de commande UC, par exemple portée par un circuit intégré, par exemple sur un ASIC (Application Specific Integrated Circuit en terminologie anglo-saxonne) ou circuit intégré exclusivement dédié à une application.

Par exemple on découpe le premier sous-ensemble E1 à l'opposé du piston de sorte à dégager un contact porté par le deuxième sous-ensemble et on réalise une connexion par un fil entre l'ASIC et le contact.

L'élément obtenu est représenté sur la figure 2M.

Ensuite, on surmoule un matériau plastique sur l'ASIC, le fil et la portion dégagée sur deuxième sous-ensemble. Ce surmoulage assure la fonction de packaging et protège l'ASIC et la connexion.

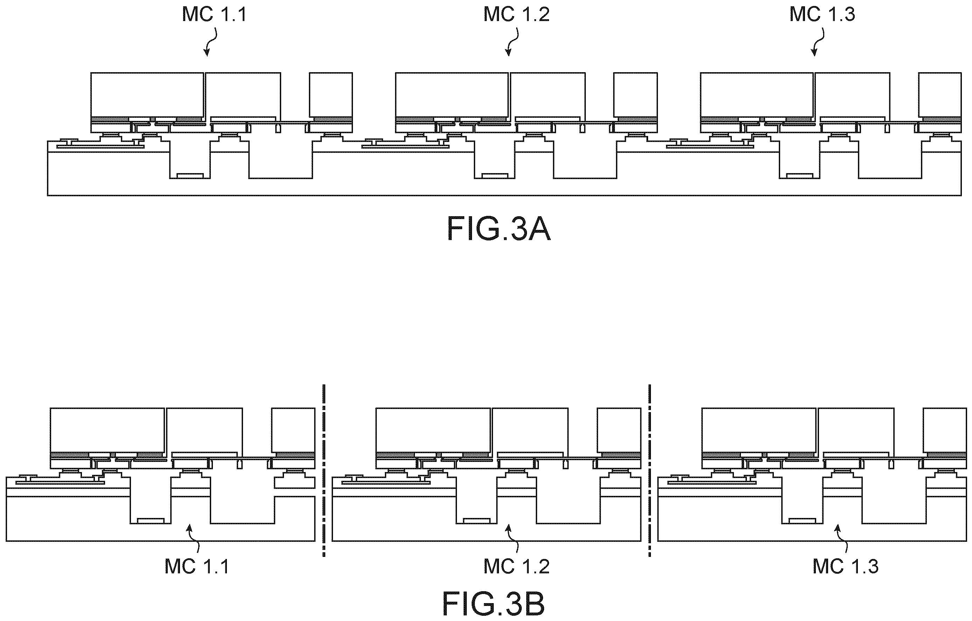

Sur la figure 3A, on peut voir une pluralité de microphones MC1.1, MC1.2, MC1.3 réalisés simultanément.

Sur la figure 3B, les microphones MC1.1, MC1.2, MC1.3 sont singularisés, par exemple par une découpe symbolisée par les traits interrompus.

Dans l'exemple représenté, les cavités gravées dans le substrat 112 ont les mêmes profondeurs, mais il peut être envisagé qu'elles aient des profondeurs différentes. En effet, on souhaite préférentiellement disposer d'un volume arrière important, la cavité destinée à délimiter en partie ce volume est préférentiellement de grandes dimensions. Concernant la chambre de mesure il est préférable qu'il y règne une faible pression, ce qui est facilité lorsque le volume est important. En variante, Il peut être envisagé de ne pas réaliser une cavité 119 si la face avant du deuxième sous-ensemble est structurée de sorte à permettre le déplacement des moyens de transmission.

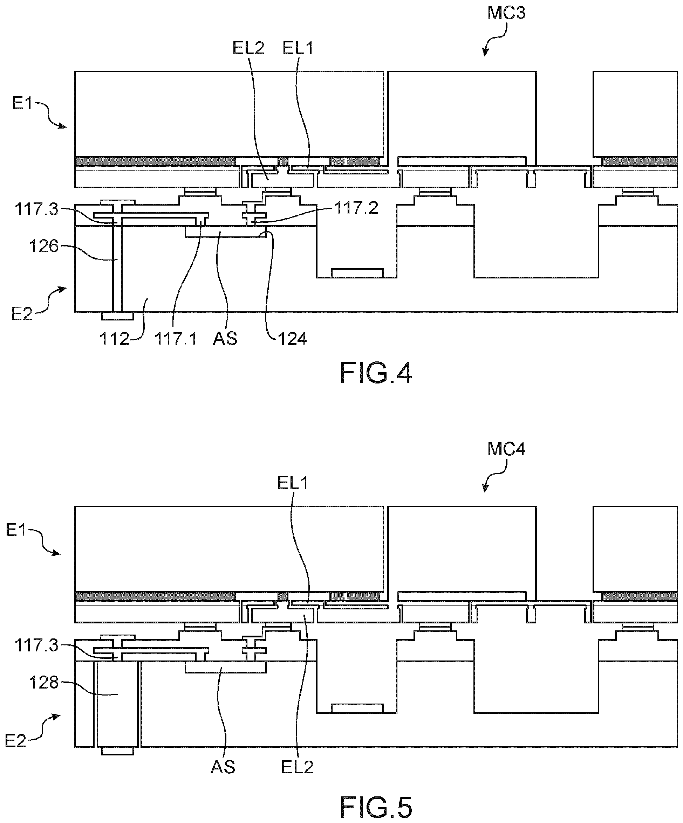

Sur la figure 4, on peut voir un autre exemple de réalisation d'un microphone MC3 formé directement par l'assemblage d'une unité microphone (sous-ensemble E1) et d'un capot (sous-ensemble E2), dans lequel l'unité de commande, par exemple l'ASIC, est intégrée dans le substrat 112 avant formation de la couche de SiO₂ 114. Par exemple la face avant du substrat 112 est structurée pour former un logement 124 pour loger l'ASIC. Puis, après la formation de la couche 114 sur le substrat 112, elle est structurée pour donner accès à l'ASIC et également à une zone du substrat 112. Ensuite, lors de la formation de la couche de métal 116, des vias 117.1, 117.2 connectés à l'ASIC sont formés simultanément et un via 117.3 débouchant sur le substrat 112. L'ASIC est connecté aux connecteurs formés dans la couche de métal 116. Lors de la formation des reprises de contact à partir de la couche 122, l'ASIC est connecté à la face avant du deuxième sous-ensemble et va être connecté à l'électrode fixe EL2 lors de l'assemblage avec le premier sous-ensemble.

Un via de type TSV (Through Silicon Via) 126 est formé à travers le substrat 112 au droit du via 117.3 et permet de relier un connecteur de la couche de métal 116 à la face arrière du substrat pour une connexion avec l'extérieur pour récupérer le signal et fournir l'alimentation électrique.

L'ASIC étant intégré au deuxième sous-ensemble, il n'est plus nécessaire de découper le premier ensemble pour accéder au contact électrique, ni de réaliser une encapsulation de l'ASIC pour le protéger. Le microphone est autonome.

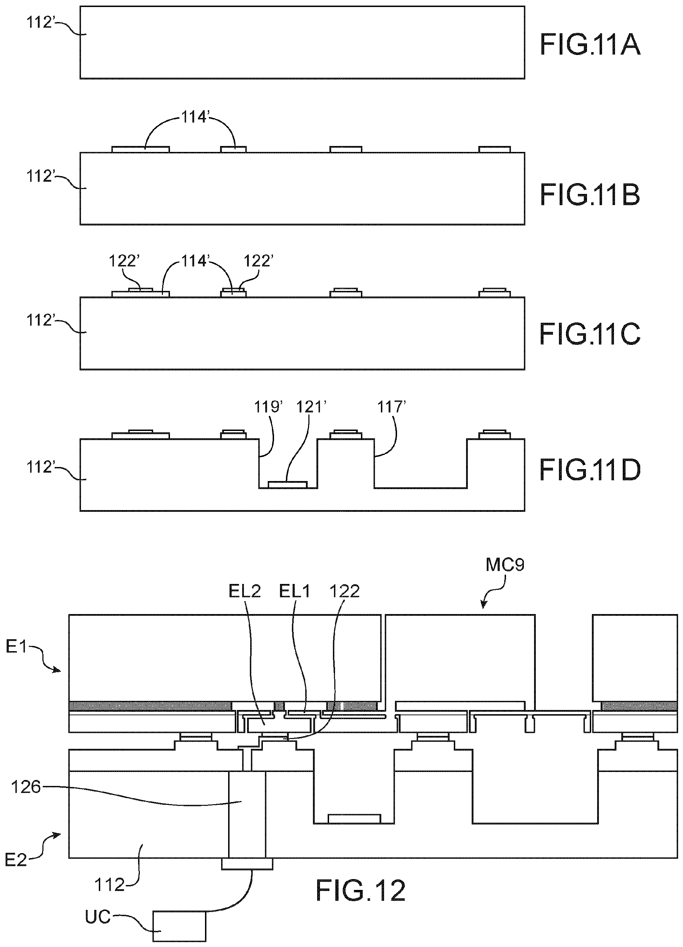

Sur la figure 12, on peut voir une variante d'un microphone MC9 dans laquelle l'unité de commande UC est extérieure aux ensembles E1 et E2, et un via 126 traversant le substrat 112 à l'aplomb de la cavité sous vide est formé. Le via 126 se connecte à la couche de métal 122 qui est en contact électrique avec l'électrode fixe EL2. L'unité de commande UC est connectée au via 126. La couche de métal 122 forme à la fois la reprise de contact, le routage et le scellement eutectique.

Sur la figure 5, on peut voir une variante du microphone MC4 de la figure 4 dans lequel on remplace le TSV par un via en silicium dopé. Pour cela le substrat est réalisé en silicium dopé et on forme une tranchée de sorte à délimiter une colonne de silicium 128 au droit du via 117.3, qui va permettre de relier l'ASIC à l'extérieur.

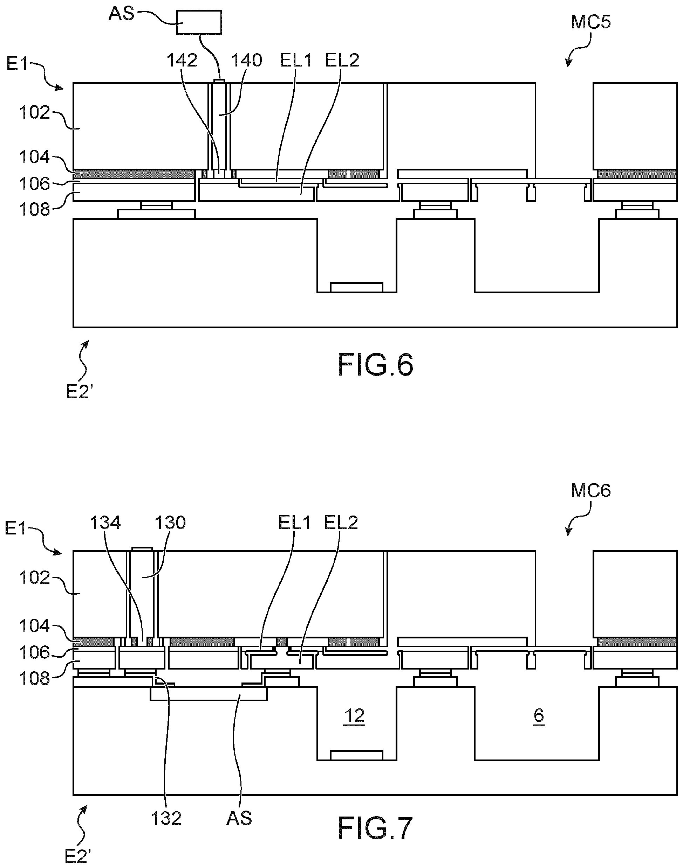

Sur les figures 6 à 9, on peut voir d'autres exemples de microphones formés également directement par l'assemblage d'une unité microphone (sous-ensemble E1) et d'un capot (sous-ensemble E2'). Les étapes de fabrication du deuxième sous-ensemble E2' de ces exemples de microphone diffèrent de celles du deuxième sous-ensemble E2. On peut voir sur les figures 11A à 11D, un exemple de fabrication du deuxième sous-ensemble E2'. A partir du substrat 112' par exemple en Si, on forme une couche d'oxyde 114' qui est structurée. L'élément obtenu est représenté sur la figure 11B.

Ensuite on forme une couche métallique 122' qui est également structurée de sorte à ne présenter que des portions sur la couche 114' structurée. Avantageusement on forme la couche d'oxyde 114' et la couche métallique 122' et on structure les couches 114' et 122' simultanément.

L'élément obtenu est représenté sur la figure 11C.

Lors d'une étape suivante, l'élément de la figure 11C est structuré pour former des cavités 117', 119' destinées à former le volume arrière et la chambre de mesure respectivement. Par exemple le substrat 112' est gravé par gravure réactive ionique profonde ou DRIE (Deep Reactive Ion Etching en terminologie anglo-saxonne).

Dans l'exemple représenté, un matériau Getter 121' est déposé dans le fond de la cavité 119' pour confirmer la faible pression dans la chambre de mesure.

L'élément obtenu est représenté sur la figure 11D, il s'agit du deuxième sous-ensemble E2'.

Ensuite les sous-ensembles E1 et E2' sont assemblés par exemple par scellement eutectique par leurs faces avant.

Sur la figure 6, on peut voir un exemple du microphone MC5 réalisé à partir des sous-ensembles E1 et E2'.

L'électrode fixe EL2 est connectée à l'ASIC AS par un via 140 à travers les couches en SiO₂ 102. Dans cet exemple, la forme de l'électrode fixe et celle de l'électrode mobile différent de celles des électrodes des exemples précédents. Dans cet exemple, l'électrode mobile n'entoure pas l'électrode fixe.

Dans cet exemple, le premier sous-ensemble E1 est réalisé par exemple en silicium dopé et le via 140 est formé en creusant une tranchée de sorte à délimiter une colonne de silicium dopé. Il est noté que lors de la fabrication du premier sous-ensemble, notamment lors de la structuration des couches 104 et 106, il est prévu d'ouvrir les couches 104 et 106 pour accéder au substrat 102 afin de réaliser un via en silicium 142 à travers la couche 104 lors de la formation de la couche de Si 108, et ainsi assurer une continuité en Si sur toute l'épaisseur du premier sous-ensemble. En variante un TSV est prévu à la place du via 140.

Sur la figure 7, on peut voir un exemple du microphone MC6 réalisé à partir des sous-ensembles E1 et E2'. Entre les étapes des figures 11A et 11B, avant la formation de la couche d'oxyde 114', un logement est formé dans la face avant du sous ensemble E2' pour loger un ASIC et lors de l'étape 11C, les couches 114' et 122' sont structurées pour assurer une reprise de contact 132 sur l'ASIC. La connexion vers l'extérieur est réalisée à travers le premier sous-ensemble. Un via 130 est réalisé sur toute l'épaisseur du premier sous-ensemble E1 et débouche au droit du contact 132 relié à l'ASIC. Dans cet exemple, le premier sous-ensemble E1 est réalisé par exemple en silicium dopé et le via est formé en creusant une tranchée de sorte à délimiter une colonne de silicium dopé. Il est noté que lors de la fabrication du premier sous-ensemble, notamment lors de la structuration des couches 104 et 106, il est prévu d'ouvrir les couches 104 et 106 pour accéder au substrat 102 afin de réaliser un via en silicium 134 à travers la couche 104 lors de la formation de la couche de Si 108 et ainsi assurer une continuité en Si sur toute l'épaisseur du premier sous-ensemble. En variante un TSV est prévu à la place du via 130.

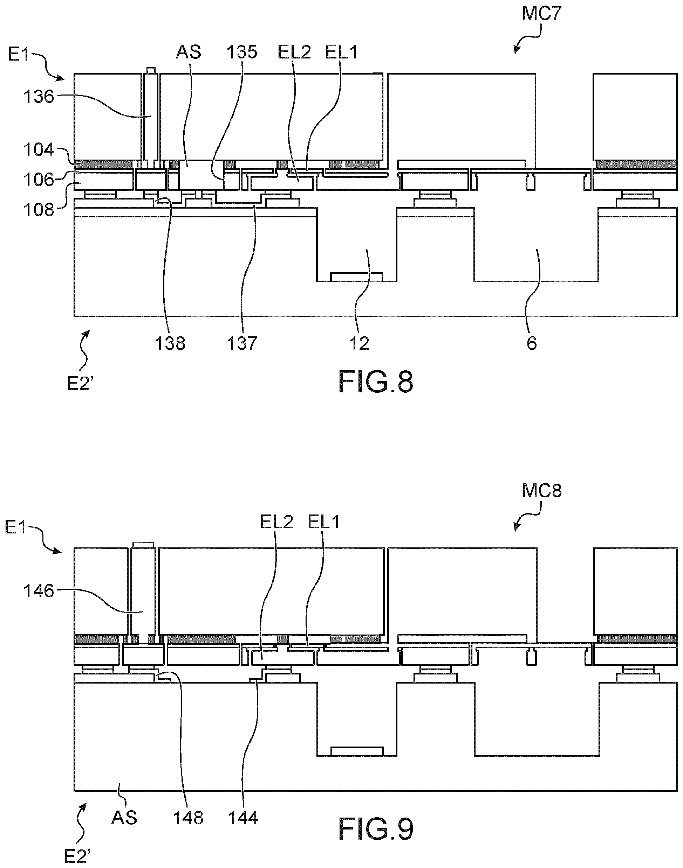

Sur la figure 8, on peut voir un autre exemple de réalisation d'un microphone MC7 dans lequel l'ASIC est intégré au premier sous-ensemble.

Dans cet exemple, le logement 135 pour l'ASIC est formé en face avant du premier sous-ensemble en structurant les couches 104, 106 et 108.

L'électrode fixe est connectée à l'ASIC AS au moyen d'une piste conductrice 137 formée sur la face avant du deuxième sous-ensemble E2 ' et l'ASIC est relié à l'extérieur au moyen d'un via 136 formé sur toute l'épaisseur du premier sous-ensemble. Une piste conductrice 138 est formée sur la face avant du deuxième sous-ensemble E2' et raccorde l'ASIC et l'extrémité du via 136 débouchant dans la face avant du premier sous-ensemble.

Lors de l'étape 11B, la couche d'oxyde 114' est structurée de sorte à ne pas découvrir la face avant du substrat 112' et permettre la réalisation de pistes conductrices s'étendant du la face avant du deuxième sous-ensemble E2'et isolées du substrat 112'.

Sur la figure 9, on peut voir un autre exemple de réalisation d'un microphone MC8 selon l'invention dans lequel le substrat du deuxième sous-ensemble est un ASIC AS. L'électrode fixe EL2 est reliée à l'ASIC AS par un contact 144 formé à l'étape 11C, et l'ASIC est relié à l'extérieur par un via 146 à travers le substrat du premier sous-ensemble et un contact 148 formé lors de l'étape 11C.

Il sera compris que tout moyen de mesure peut être mis en œuvre dans la chambre étanche tel que des moyens piézorésistifs ou piézoélectriques comportant une ou plusieurs jauges de contrainte ou des moyens de détection mettant en œuvre des poutres résonantes.

## Revendications

1. Microphone microélectromécanique comportant :
- une unité microphone réalisée à partir d'un premier substrat, l'unité microphone comportant un élément mobile (4) apte à se déplacer sous l'effet d'une différence de pression entre un environnement extérieur et une première cavité (6) et des moyens de mesure du déplacement de l'élément mobile,
- un capot réalisé à partir d'un deuxième substrat, ledit capot comportant au moins un premier évidement,
- des premiers moyens de connexion électrique des moyens de mesure (10) à une unité de commande,
l'unité microphone et le capot étant assemblés de sorte qu'ils délimitent entre eux un espace sous atmosphère contrôlée, l'atmosphère contrôlée étant à une pression inférieure à la pression atmosphérique, avantageusement sous vide, logeant les moyens de mesure et la première cavité (6) à partir du premier évidement, l'élément mobile comportant une première face (4.2) orientée du côté de l'environnement extérieur et une deuxième face (4.1) orientée du côté de la première cavité (6), l'élément mobile fermant en partie ladite première cavité (6) de sorte que la première cavité soit en communication fluidique avec l'environnement extérieur, l'espace sous atmosphère contrôlée et la première cavité (6) étant isolés de manière étanche l'un de l'autre, ledit microphone comportant également des moyens de transmission mécanique (8) du déplacement de l'élément mobile (4) aux moyens de mesure (10) et un élément d'isolation étanche (16) situé dans un plan, traversé par les moyens de transmission (8) et assurant le passage étanche des moyens de transmission (8) entre l'environnement extérieur et une chambre de mesure (12) formée par l'espace sous atmosphère contrôlée tout en maintenant l'isolation étanche, dans lequel l'espace sous atmosphère contrôlée et la première cavité (6) sont d'un même côté du plan de l'élément d'isolation étanche (16).

2. Microphone microélectromécanique selon la revendication 1, dans lequel le capot comporte un deuxième évidement (12) qui délimite avec l'unité microphone l'espace sous atmosphère contrôlée.

3. Microphone microélectromécanique selon la revendication 1 ou 2, dans lequel les moyens de connexion sont dans le capot et sont formés par au moins un via et/ou de pistes de connexion s'étendant dans le plan du capot.

4. Microphone microélectromécanique selon la revendication 1 ou 2, dans lequel les moyens de connexion sont dans l'unité microphone et sont formés par au moins un via.

5. Microphone microélectromécanique selon l'une des revendications 1 à 4, dans lequel l'unité de commande est un ASIC intégré au premier substrat ou au deuxième substrat.

6. Microphone microélectromécanique selon l'une des revendications 1 à 5, dans lequel les moyens de mesure sont capacitifs et comprennent une électrode fixe sur le premier substrat et une électrode solidaire des moyens de transmission, ou dans lequel les moyens de mesure sont des moyens de mesure mettant en œuvre des poutres résonantes.

7. Procédé de fabrication d'au moins un microphone comportant un élément mobile (4) configuré pour se déplacer sous l'effet d'une différence de pression entre un environnement extérieur et une première cavité, l'élément mobile (4) comportant une première face (4.2) orientée du côté de l'environnement extérieur et une deuxième face (4.1) orientée du côté de la première cavité (6), ladite première cavité (6) étant connectée fluidiquement à l'environnement extérieur, des moyens de mesure (10) du déplacement de l'élément mobile (4), lesdits moyens de mesure (10) étant logés dans une chambre de mesure (12) isolée de manière étanche de l'environnement extérieur, des moyens de transmission mécanique (8) du déplacement de l'élément mobile (4) aux moyens de mesure (10) reliant l'élément mobile (4) et au moins une partie des moyens de mesure (10), un élément d'isolation étanche (16) situé dans un plan, traversé par les moyens de transmission (8) et assurant le passage étanche des moyens de transmission (8) entre l'environnement extérieur et la chambre de mesure (12) toute en maintenant l'isolation étanche, ledit procédé comportant :
a) la fabrication d'un premier sous-ensemble comportant la partie mobile, une partie des moyens de transmission mécanique, l'élément d'isolation étanche (16) et une partie au moins des moyens de mesure,
b) la fabrication d'un deuxième sous-ensemble comportant au moins la première cavité,
c) la fabrication de premiers moyens de connexion électrique destinés à connecter les moyens de mesure à une unité de commande,
d) l'assemblage du premier sous-ensemble et du deuxième sous-ensemble de sorte qu'ils délimitent un espace sous atmosphère contrôlée à une pression inférieure à la pression atmosphérique, de sorte que l'espace sous atmosphère contrôlée et la première cavité (6) soient d'un même côté du plan de l'élément d'isolation étanche (16), et de sorte que la première cavité soit en regard de la deuxième face de l'élément mobile et les premiers moyens de connexion électrique soient en contact électrique avec les moyens de mesure, et de sorte à former la chambre de mesure (12) isolée de manière étanche de l'environnement extérieur,
e) structuration du premier sous-ensemble pour former l'autre partie des moyens de transmission et libération de l'élément mobile, des moyens de transmission mécanique et des moyens de mesure,
f) connexion des moyens de mesure (10) à une unité de commande.

8. Procédé de fabrication selon la revendication 7, dans lequel lors de l'assemblage du premier sous-ensemble et du deuxième sous-ensemble une atmosphère contrôlée est établie dans la chambre de mesure (12).

9. Procédé de fabrication selon la revendication 7 ou 8, dans lequel lors de l'étape b), une deuxième cavité (119) adjacente à la première cavité est formée et délimite avec le premier sous-ensemble la chambre de mesure (12).

10. Procédé de fabrication selon la revendication 7, 8 ou 9, dans lequel la fabrication des premiers moyens de connexion comporte la réalisation d'un via à travers le premier sous-ensemble débouchant en face avant du premier sous-ensemble et se connectant directement aux moyens de mesure.

11. Procédé de fabrication selon l'une des revendications 7 à 10, dans lequel les premiers moyens de connexion sont fabriqués sur le deuxième sous-ensemble et dans lequel l'étape f) comporte la découpe d'une partie du premier sous-ensemble pour accéder aux premiers moyens de connexion électrique du deuxième sous-ensemble, et la connexion des premiers moyens de connexion électrique à l'unité de commande, avantageusement dans lequel l'étape f) comporte une étape d'encapsulation de l'unité de commande, des premiers moyens de connexion électrique et d'une partie du premier sous-ensemble et du deuxième sous-ensemble.

12. Procédé de fabrication selon l'une des revendications 7 à 9, l'unité de commande étant un ASIC (AS), le procédé comportant une étape d'intégration de l'ASIC dans le premier ou le deuxième sous-ensemble, ledit procédé comportant avantageusement la fabrication d'un logement (135, 124) en face avant du premier ou deuxième sous-ensemble et mise en place de l'ASIC (AS) dans ledit logement (135, 134).

13. Procédé de fabrication selon la revendication 12, comportant la réalisation de deuxièmes moyens de connexion à l'ASIC (AS) et la réalisation d'un via dans le premier sous-ensemble ou le deuxième sous-ensemble de sorte qu'il se connecte aux deuxièmes moyens de connexion.

14. Procédé de fabrication selon l'une des revendications 7 à 9, dans lequel le deuxième sous-ensemble est formé à partir d'un substrat, ledit substrat intégrant un ASIC.

15. Procédé de fabrication selon l'une des revendications 7 à 14, dans lequel plusieurs microphones sont fabriqués simultanément, lesdits premiers sous-ensembles étant réalisés à partir d'un même substrat et lesdits deuxièmes sous-ensembles étant réalisés à partir d'un même deuxième substrat, ledit procédé comportant une étape de séparation des microphones après l'étape e).

## Patentansprüche

1. Mikroelektromechanisches Mikrofon, das Folgendes aufweist:
- eine Mikrofoneinheit, die aus einem ersten Substrat hergestellt ist, wobei die Mikrofoneinheit ein mobiles Element (4) aufweist, das sich unter der Wirkung eines Druckunterschieds zwischen einer äußeren Umgebung und einem ersten Hohlraum (6) und den Messmitteln der Bewegung des mobilen Elements bewegen kann,
- eine Abdeckung, die aus einem zweiten Substrat hergestellt ist, wobei die Abdeckung mindestens eine erste Aussparung aufweist,
- erste Mittel zur elektrischen Verbindung der Messmittel (10) mit einer Steuereinheit,
wobei die Mikrofoneinheit und die Abdeckung so zusammengebaut sind, dass sie einen Raum unter kontrollierter Atmosphäre untereinander abgrenzen, wobei die kontrollierte Atmosphäre bei einem Druck unterhalb des Atmosphärendrucks, vorteilhafterweise unter Vakuum, die Messmittel und den ersten Hohlraum (6) ab der ersten Aussparung aufnimmt, wobei das mobile Element eine erste Seite (4.2) auf der Seite der äußeren Umgebung und eine zweite Seite (4.1) auf der Seite des ersten Hohlraums (6) aufweist, wobei das mobile Element den ersten Hohlraum (6) teilweise so verschließt, dass der erste Hohlraum mit der äußeren Umgebung in Fluidkommunikation steht, wobei der Raum unter kontrollierter Atmosphäre und der erste Hohlraum (6) dicht voneinander isoliert sind, wobei das Mikrofon auch mechanische Übertragungsmittel (8) für die Bewegung des mobilen Elements (4) zu den Messmitteln (10) und ein dichtes Isolationselement (16) in einer Ebene aufweist, die von den Übertragungsmitteln (8) durchflossen wird und den dichten Übergang der Übertragungsmittel (8) zwischen der äußeren Umgebung und einer Messkammer (12) gewährleistet, die durch den Raum unter kontrollierter Atmosphäre gebildet wird, während die dichte Isolierung aufrechterhalten wird, wobei der Raum unter kontrollierter Atmosphäre und der erste Hohlraum (6) sich auf derselben Seite der Ebene des dichten Isolationselements (16) befinden.

2. Mikroelektromechanisches Mikrofon nach Anspruch 1, wobei die Abdeckung eine zweite Aussparung (12) aufweist, die mit der Mikrofoneinheit den Raum unter kontrollierter Atmosphäre abgrenzt.

3. Mikroelektromechanisches Mikrofon nach Anspruch 1 oder 2, wobei sich die Verbindungsmittel in der Abdeckung befinden und durch mindestens ein Via und/oder Verbindungsbahnen gebildet sind, die sich in der Ebene der Abdeckung erstrecken.

4. Mikroelektromechanisches Mikrofon nach Anspruch 1 oder 2, wobei sich die Verbindungsmittel in der Mikrofoneinheit befinden und durch mindestens ein Via gebildet sind.

5. Mikroelektromechanisches Mikrofon nach einem der Ansprüche 1 bis 4, wobei die Steuereinheit ein in das erste Substrat oder das zweite Substrat integriertes ASIC ist.

6. Mikroelektromechanisches Mikrofon nach einem der Ansprüche 1 bis 5, wobei die Messmittel kapazitiv sind und eine feste Elektrode auf dem ersten Substrat und eine Elektrode umfassen, die fest mit den Übertragungsmitteln verbunden ist, oder wobei die Messmittel Messmittel sind, die Resonanzträger einsetzen.

7. Verfahren zur Herstellung mindestens eines Mikrofons, das ein mobiles Element (4), das so eingerichtet ist, dass es sich unter der Wirkung eines Druckunterschieds zwischen einer äußeren Umgebung und einem ersten Hohlraum bewegt, wobei das mobile Element (4) eine erste Seite (4.2) auf der Seite der äußeren Umgebung und eine zweite Seite (4.1) auf der Seite des ersten Hohlraums (6), wobei der erste Hohlraum (6) fluidisch mit der äußeren Umgebung verbunden ist, Messmittel (10) zum Bewegen des mobilen Elements (4), wobei die Messmittel (10) in einer von der äußeren Umgebung dicht isolierten Messkammer (12) untergebracht sind, mechanische Übertragungsmittel (8) zum Bewegen des mobilen Elements (4) zu den Messmitteln (10), die das mobile Element (4) und mindestens einen Teil der Messmittel (10) verbinden, ein dichtes Isolierelement (16) in einer Ebene, durch das die Übertragungsmittel (8) hindurchgehen und das den dichten Übergang der Übertragungsmittel (8) zwischen der äußeren Umgebung und der Messkammer (12) bei gleichzeitiger Aufrechterhaltung der dichten Isolierung sicherstellt, aufweist, wobei das Verfahren Folgendes umfasst:
a) Herstellen einer ersten Unterbaugruppe, die den mobilen Teil, einen Teil der mechanischen Übertragungsmittel, das dichte Isolationselement (16) und mindestens einen Teil der Messmittel aufweist,
b) Herstellen einer zweiten Unterbaugruppe, die mindestens den ersten Hohlraum aufweist,
c) Herstellen erster elektrischer Verbindungsmittel, die dazu bestimmt sind, die Messmittel mit einer Steuereinheit zu verbinden,
d) Zusammenbauen der ersten Unterbaugruppe und der zweiten Unterbaugruppe, so dass sie einen Raum unter kontrollierter Atmosphäre bei einem Druck unter Atmosphärendruck abgrenzen, so dass der Raum unter kontrollierter Atmosphäre und der erste Hohlraum (6) sich auf derselben Seite der Ebene des dichten Isolationselements (16) befinden, und so, dass sich der erste Hohlraum gegenüber der zweiten Seite des mobilen Elements befindet und die ersten elektrischen Verbindungsmittel in elektrischem Kontakt mit den Messmitteln stehen, und so, dass die Messkammer (12) dicht von der äußeren Umgebung isoliert ist,
e) Strukturieren der ersten Unterbaugruppe, um den anderen Teil der Übertragungsmittel zu bilden, und Freigeben des mobilen Elements, der mechanischen Übertragungsmittel und der Messmittel,
f) Verbinden der Messmittel (10) an eine Steuereinheit.

8. Herstellungsverfahren nach Anspruch 7, wobei bei der Montage der ersten Unterbaugruppe und der zweiten Unterbaugruppe eine kontrollierte Atmosphäre in der Messkammer (12) hergestellt wird.

9. Herstellungsverfahren nach Anspruch 7 oder 8, wobei in Schritt b) ein zweiter Hohlraum (119) neben dem ersten Hohlraum gebildet wird und mit der ersten Unterbaugruppe die Messkammer (12) abgrenzt.

10. Herstellungsverfahren nach Anspruch 7, 8 oder 9, wobei die Herstellung der ersten Verbindungsmittel die Fertigung eines Vias durch die erste Unterbaugruppe aufweist, der an der Vorderseite der ersten Unterbaugruppe mündet und sich direkt mit den Messmitteln verbindet.

11. Herstellungsverfahren nach einem der Ansprüche 7 bis 10, wobei die ersten Verbindungsmittel an der zweiten Unterbaugruppe hergestellt werden und wobei der Schritt f) das Zuschneiden eines Teils der ersten Unterbaugruppe aufweist, um Zugang zu den ersten elektrischen Verbindungsmitteln der zweiten Unterbaugruppe zu erhalten, und das Verbinden der ersten elektrischen Verbindungsmittel mit der Steuereinheit, wobei der Schritt f) einen Schritt des Verkapselns der Steuereinheit, der ersten elektrischen Verbindungsmittel und eines Teils der ersten Unterbaugruppe und der zweiten Unterbaugruppe aufweist.

12. Herstellungsverfahren nach einem der Ansprüche 7 bis 9, wobei die Steuereinheit ein ASIC (AS) ist, wobei das Verfahren einen Schritt der Integration des ASIC in die erste oder zweite Unterbaugruppe aufweist, wobei das Verfahren vorteilhaft das Herstellen eines Gehäuses (135, 124) an der Vorderseite der ersten oder zweiten Unterbaugruppe und das Einsetzen des ASIC (AS) in das Gehäuse (135, 134) aufweist.

13. Herstellungsverfahren nach Anspruch 12, das die Fertigung zweiter Verbindungsmittel zum ASIC (AS) und die Fertigung eines Vias in der ersten Unterbaugruppe oder der zweiten Unterbaugruppe aufweist, so dass es sich mit den zweiten Verbindungsmitteln verbindet.

14. Herstellungsverfahren nach einem der Ansprüche 7 bis 9, wobei die zweite Unterbaugruppe aus einem Substrat gebildet ist, wobei das Substrat einen ASIC integriert.

15. Herstellungsverfahren nach einem der Ansprüche 7 bis 14, wobei mehrere Mikrofone gleichzeitig hergestellt werden, wobei die ersten Unterbaugruppen aus demselben Substrat und die zweiten Unterbaugruppen aus demselben zweiten Substrat gefertigt sind, wobei das Verfahren einen Schritt der Trennung der Mikrofone nach Schritt e) aufweist.

## Claims

1. A micro-electromechanical microphone comprising:
- a microphone unit made from a first substrate, the microphone unit comprising a movable element (4) capable of moving under the effect of a pressure difference between an external environment and a first cavity (6) and means for measuring the movement of the movable element,
- a cover made from a second substrate, said cover comprising at least one first recess,
- first means for electrically connecting the measuring means (10) to a control unit,
the microphone unit and the cover being assembled so as to delimit a space under controlled atmosphere between them, the controlled atmosphere being at a pressure lower than atmospheric pressure, advantageously under vacuum, housing the measuring means and the first cavity (6) from the first recess, the movable element comprising a first face (4.2) oriented to the side of the external environment and a second face (4.1) oriented to the side of the first cavity (6), the movable element partly closing said first cavity (6) so that the first cavity is in fluid communication with the external environment, the space under controlled atmosphere and the first cavity (6) being sealingly insulated from each other, said microphone also comprising means (8) for mechanically transmitting the movement of the movable element (4) to the measuring means (10) and a sealed insulation element (16) located in a plane, through which the transmission means (8) passes and ensuring sealed passage of the transmission means (8) between the external environment and a measuring chamber (12) formed by the space under controlled atmosphere while maintaining the sealed insulation, wherein the space under controlled atmosphere and the first cavity (6) are on a same side of the plane of the sealed insulation element (16).

2. The micro-electromechanical microphone according to claim 1, wherein the cover comprises a second recess (12) that delimits the space under controlled atmosphere together with the microphone unit.

3. The micro-electromechanical microphone according to claim 1 or 2, wherein the connection means are in the cover and are formed by at least one via and/or connection tracks extending in the plane of the cover.

4. The micro-electromechanical microphone according to claim 1 or 2, wherein the connection means are in the microphone unit and are formed by at least one via.

5. The microelectromechanical microphone according to one of claims 1 to 4, wherein the control unit is an ASIC integrated into the first substrate or the second substrate.

6. The micro-electromechanical microphone according to one of claims 1 to 5, wherein the measuring means are capacitive and comprise a fixed electrode on the first substrate and an electrode integral with the transmission means, or wherein the measuring means are measuring means implementing resonant beams.

7. A method for manufacturing at least one microphone comprising a movable element (4) configured to move under the effect of a pressure difference between an external environment and a first cavity, the movable element (4) comprising a first face (4.2) oriented to the side of the external environment and a second face (4.1) oriented to the side of the first cavity (6), said first cavity (6) being fluidly connected to the external environment, means (10) for measuring the movement of the movable element (4), said measuring means (10) being housed in a measuring chamber (12) sealingly insulated from the external environment, means (8) for mechanically transmitting the movement of the movable element (4) to the measuring means (10) connecting the movable element (4) and at least one part of the measuring means (10), a sealed insulation element (16) located in a plane, through which the transmission means (8) pass and ensuring sealed passage of the transmission means (8) between the external environment and the measuring chamber (12) while maintaining the sealed insulation, said method comprising:
a) manufacturing a first subassembly comprising the movable part, a part of the mechanical transmission means, the sealed insulation element (16) and at least one part of the measuring means,
b) manufacturing a second subassembly comprising at least the first cavity,
c) manufacturing first electrical connection means for connecting the measurement means to a control unit,
d) assembling the first sub-assembly and the second sub-assembly so that they delimit a space under controlled atmosphere at a pressure lower than atmospheric pressure, so that the space under controlled atmosphere and the first cavity (6) are on a same side of the plane of the sealed insulating element (16), and so that the first cavity is facing the second face of the movable element and the first electrical connection means are in electrical contact with the measuring means, and so as to form the measuring chamber (12) sealingly insulated from the external environment,
e) structuring the first subassembly to form the other part of the transmission means and releasing the movable element, the mechanical transmission means and the measuring means,
f) connecting the measuring means (10) to a control unit.

8. The manufacturing method according to claim 7, wherein upon assembling the first sub-assembly and the second sub-assembly, a controlled atmosphere is established in the measuring chamber (12).

9. The manufacturing method according to claim 7 or 8, wherein during step b), a second cavity (119) adjacent to the first cavity is formed and delimits the measuring chamber (12) together with the first subassembly.

10. The manufacturing method according to claim 7, 8 or 9, wherein manufacturing the first connection means comprises making a via through the first sub-assembly opening onto the front face of the first sub-assembly and connecting directly to the measuring means.

11. The manufacturing method according to one of claims 7 to 10, wherein the first connection means are manufactured on the second sub-assembly and wherein the step f) comprises cutting a part of the first sub-assembly to access the first electrical connection means of the second sub-assembly, and connecting the first electrical connection means to the control unit, advantageously wherein step f) comprises a step of encapsulating the control unit, the first electrical connection means and a part of the first sub-assembly and the second sub-assembly.

12. The manufacturing method according to one of claims 7 to 9, the control unit being an ASIC (AS), the method comprising a step of integrating the ASIC into the first or second sub-assembly, said method advantageously comprising manufacturing a housing (135, 124) on the front face of the first or second sub-assembly and installing the ASIC (AS) in said housing (135, 134).

13. The manufacturing method according to claim 12, comprising making second means for connecting to the ASIC (AS) and making a via in the first sub-assembly or the second sub-assembly so that it connects to the second connection means.

14. The manufacturing method according to one of claims 7 to 9, wherein the second subassembly is formed from a substrate, said substrate integrating an ASIC.

15. The manufacturing method according to one of claims 7 to 14, wherein several microphones are manufactured simultaneously, said first subassemblies being made from a same substrate and said second subassemblies being made from a same second substrate, said method comprising a step of separating the microphones after step e).
